# EUROPÄISCHE PATENTSCHRIFT

(11) **EP 0 612 778 B1**
(45) Veröffentlichungstag und Bekanntmachung des Hinweises auf die Patenterteilung: **16.04.1997**
(21) Anmeldenummer: 94100350.1
(22) Anmeldetag: 12.01.1994
(51) Int. Cl.: C08G 59/20, C08G 59/38, H01L 23/29, H01B 3/40, C08J 5/24

(54) **Epoxidharzsystem**
Epoxy resin composition
Composition de résines époxydes

(30) Priorität: 10.02.1993 DE 4303824
(43) Veröffentlichungstag der Anmeldung: 31.08.1994
(73) Patentinhaber: Bakelite AG, 58642 Iserlohn-Letmathe (DE)
(72) Erfinder: Böttcher, Axel, Dr., D-46483 Wesel (DE); Zehrfeld, Jürgen, Dr., D-46562 Voerde (DE); Dey, Holger, D-47179 Duisburg (DE); Herzog, Rolf, Dr., D-46240 Bottrop (DE)

(56) Entgegenhaltungen:
- EP-A- 0 384 939
- EP-A- 0 408 990
- WO-A-91/13925
- US-A- 5 155 198

## Beschreibung

Die Erfindung betrifft ein System aus Epoxidverbindungen und Härter, das frei ist von halogenierten Verbindungen und das dennoch schwer brennbar ist.

Derartige Epoxidharzsysteme sind insbesondere erwünscht im Elektroniksektor, sei es zur Herstellung von Leiterplatten oder von Epoxidharz-Form- oder -gießmassen zur Umhüllung oder zum Einbetten von elektrischen oder elektronischen Bauteilen. In diesen Anwendungsgebieten sind hohe T_{g}-Werte der gehärteten Produkte gefordert. Entsprechende Systeme sind aus EP-A 0 384 939 und EP-A 0 408 990 bekannt.

Gemäß EP-A 0 384 939 wird ein phosphorfreies Epoxidharz mit einer epoxidhaltigen Phosphorverbindung gemischt und mit einem aromatischen Polyamin spezieller Struktur ausgehärtet.

Nach EP-A 0 408 990 werden ein phosphorfreies Epoxidharz, eine epoxidgruppenhaltige Phosphorverbindung und ein polyfunktionelles Isocyanat miteinander kombiniert und mittels eines aminischen Härters, eines Bor-Amin-Komplexes oder einem Oniumsalz gehärtet.

Mit beiden Systemen werden hohe Glasübergangstemperaturen (T_{g} > 160 °C) sowie eine Schwerbrennbarkeit (Einstufung nach UL 94 V : VO) erreicht. Nachteilig ist bei beiden Systemen, daß die Aushärtung sehr lange Behandlung bei hohen Temperaturen (z. B. 8 h bei 150 °C und 16 h bei 200 °C) erfordert. Dies ist äußerst unwirtschaftlich und bedingt zudem Verwerfungen im Laminat bei der Verpressung zum Leiterplattenmaterial, was als Restwelligkeit bezeichnet wird, und durch eine Verpressung bei Temperaturen oberhalb der T_{g} bewirkt wird.

Es ist daher Aufgabe der vorliegenden Erfindung, Epoxidharzsysteme bereitzustellen, die frei sind von halogenierten Verbindungen, die ohne Zusatz von Flammschutzmitteln, wie z. B. Antimonoxiden schwerbrennbar sind, die die guten physikalischen Eigenschaften, insbesondere die hohen Glasübergangstemperaturen haben, wie sie für die Einstufung nach VO gefordert werden (T_{g} > 160 °C), die aber in wesentlich kürzerer Zeit bei Temperaturen unterhalb der Glasübergangstemperatur ausgehärtet werden können.

Die Lösung der Aufgabe erfolgt durch Epoxidharzsysteme gemäß der Ansprüche 1 bis 3. Diese Systeme finden bevorzugt Verwendung zur Herstellung von Leiterplattenbasismaterial, von Prepregs für die Herstellung von faserverstärkten Formkörpern oder zur Umhüllung oder Einbettung von elektrischen oder elektronischen Bauelementen oder als Gießharze geeignet, gemäß der Ansprüche 4 bis 6.

Die erfindungsgemäßen Epoxidharzsysteme enthalten mindestens eine stickstoffhaltige Epoxidverbindung mit mindestens zwei Epoxidgruppen pro Molekül, mindestens eine Phosphorverbindung mit mindestens einer, bevorzugt mit mindestens zwei Epoxidgruppen sowie mindestens eine Metallkomplexverbindung als Härter. Sie können darüberhinaus weitere an sich bekannte Füll- und Zusatzstoffe, wie Beschleuniger, Lösemittel, Pigmente oder Thixotropiermittel aber auch weitere Polyglycidylether oder epoxiderte Novolake enthalten.

Diese Epoxidharz-Härter-Systeme sind schwerbrennbar nach UL 94 VO und lassen sich in 3 bis 10 min. bei Temperaturen auch unterhalb des T_{g} vorzugsweise im Bereich von 150 bis 175 °C vollständig durchhärten. Ein Nachtempern ist nicht notwendig. Die Systeme eignen sich vorzüglich für die Herstellung von Prepregs. Sofern Lösemittel eingesetzt werden, sind niedrig siedende Lösemittel, wie etwa Methylethylketon einsetzbar. Andererseits kann die Prepregherstellung auch ohne Verwendung von Lösemitteln in einem Hotmelt-Prozeß erfolgen.

Die erhaltenen Prepregs sind bei Umgebungstemperatur mehrere Monate lagerstabil. Die kurzen Härtungszeiten bei relativ niedriger Temperatur erlauben zudem kurze Preßzeiten. Eine thermische Nachbehandlung so hergestellter Verbundwerkstoffe oder Leiterplatten ist nicht notwendig. Verbundwerkstoffe und Leiterplatten zeigen keine Verwerfungen. Andererseits haben sie so gute mechanische und elektrische Eigenschaften, daß für entsprechende Leiterplatten mindestens die Einstufung FR-5 gegeben ist.

Erfindungsgemäß einsetzbare stickstoffhaltige Epoxidverbindungen sind Umsetzungsprodukte aus Epichlorhydrin und di- oder polyfunktionellen stickstoffhaltigen Verbindungen. Beispiele hierfür sind Polyglycidylether von polymeren Amiden oder Sulfonamiden, von Cyanursäure, Melaminen, Aminophenolen oder Polyaminen. Bevorzugte Polyamine sind Dodecylhydro-1,4,7,9'-tetraazaphenalen, Xylylendiamine, p-Phenylendiamin, insbesondere aber 4,4'-Methylendianilin und 4,4'-Diaminodiphenylsulfon.

Die Herstellung entsprechender Epoxidverbindungen erfolgt in an sich bekannter Weise, wie sie z. B. auch in Lee und Neville, Handbook of Epoxy Resins, McGraw-Hill Book Company (1967) beschrieben ist.

Die bevorzugten Epoxidverbindungen sind Tetraglycidyl-methylendianilin (TGMDA) und Tetraglycidyl-diaminodiphenylsulfon (TGDDS), die einzeln oder im beliebigen Gemisch miteinander eingesetzt werden können.

Die einsetzbaren Phosphorverbindungen sind solche der allgemeinen Struktur: 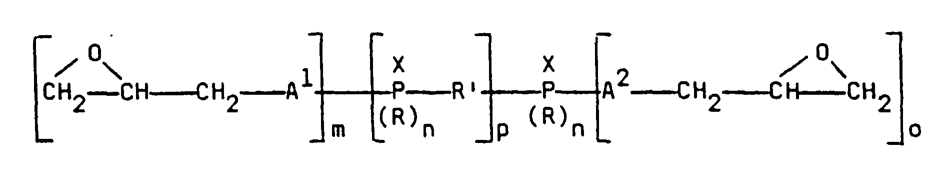
worin **m** = 0 oder 1; **n** = 0, 1 oder 2 und **o** = 1, 2 oder 3 mit der Maßgabe, daß **m** + **n** + o = 3; **p** = 0, 1 oder 2;
**X** ein freies Elektronenpaar oder ein über eine Doppelbindung gebundenes O- oder S-Atom;
**R** einen direkten oder über O oder S gebundenen Alkylrest mit 1 bis 4 C-Atomen, Alkenylrest mit 2 bis 3 C-Atomen, Arylrest, Aralkylrest, oder 3-Trialkylsilyl-propylrest;
**R'** eine Brücke aus O, S, Phenylen, Dioxyphenylen, Dioxynaphthylen, (CH₂)ᵣ, O-(CH₂)ᵣ, O-(CH₂)ᵣ-O oder O-(CH₂)ᵣ-(Si(CH₃)₂-O )ₛ-Si(CH₃)₂(CH₂)ᵣ-O mit **r** = 1 bis 3 und **s** = 1 bis 8 oder (O-CH₂-CH₂)ₜ-O, (O-CH(CH₃)-CH₂)ₜ oder (O-(CH₂)₄)ₜ-O mit **t** = 2 bis 100 bedeuten und A¹ und A², die gleich oder verschieden sein können und eine Einfachbindung oder ein Brücke entsprechend der Gruppierung R' bedeuten.

Als Phosphorverbindungen können solche eingesetzt werden, die mindestens eine Epoxidgruppe enthalten. Diese Monoglycidyl-Phosphorverbindungen führen bei der Härtung zum Kettenabbruch und verringern somit den T_{g}-Wert des gehärteten Produkts. Sie werden daher meist in Abmischung mit Polyepoxy-Phosphorverbindungen eingesetzt in einer Menge von maximal 10 % aller Epoxyphosphorver-bindungen.

Die erfindungsgemäßen Epoxidharzsysteme enthalten die stickstoffhaltigen Epoxidverbindungen und die epoxidgruppenhaltigen Phosphorverbindungen im Gewichtsverhältnis von 50 : 50 bis 95 : 5.

Je 100 Gew.-Teile dieser Mischungen aus Epoxidverbindungen benötigen zur Härtung 0,1 bis 20 Gew.-Teile einer oder mehrerer Metallkomplexverbindungen, die die folgende Struktur haben:

MLₓB_{y} oder M [SR] ₓ B_{z},

wobei
- M ein komplexierendes Metallion
- L ein Ligand
- SR ein Säurerestion
- B eine Lewis-Base
- x eine natürliche Zahl im Bereich von 1 bis 8
- y eine natürliche Zahl im Bereich von 1 bis 5
- z eine natürliche Zahl im Bereich von 7 bis 8
sind.

Diese Metallkomplexverbindungen sind aus WO 91/13925 bekannt.

Zur Herstellung des erfindungsgemäßen Epoxidharzsystems werden die stickstoff- und die phosphorhaltigen Epoxidverbindungen miteinander und mit den Komplexen, bzw. einer Lösung (des) der Komplexe(s) in einem organischen Lösemittel bei einer Temperatur unterhalb der Initiierungstemperatur, d. h., bevorzugt im Bereich von Raumtemperatur bis 50 °C gemischt.

Dies kann entweder kurz vor der Weiterverarbeitung (Härtung) erfolgen, oder aber auch lange vor diesem Arbeitsgang, denn die Mischungen sind in diesem Temperatur-Bereich lagerfähig und können zu Form- oder Gießmassen oder Prepregs verarbeitet werden.

Die Härtung der Epoxidverbindungen erfolgt dann durch Energiezufuhr, wobei die Temperatur über die Initiierungstemperatur der Komplexe steigt.

Die Zuführung von Energie kann in Form von thermischer Energie, Licht, Mikrowellen, Strahlung, Laserenergie etc. erfolgen.

### Beispiel

- 70 GT: Tetraglycidylmethylendianilin
- 30 GT: Diglycidylphenylphosphonsäureester
- 30 GT: 10 %ige Lösung eines Komplexes der Formel [CoSO₄][Imidazol]₇ in Methylethylketon
werden bei 40 °C miteinander vermischt.

Mit der so erhaltenen Lösung werden Glasfaservliese getränkt und das Lösemittel verdampft. Die so erhaltenen Prepregs sind klebfrei und härten bei Lagerung bei Raumtemperatur nicht aus.

Acht derartige Prepregs werden miteinander verpreßt und dabei 5 min. lang bei 170 °C gehärtet. Das so hergestellte Leiterplattenbasismaterial wird auf ihre Einstufung in FR-5 geprüft.

### Ergebnis:

| Eigenschaften | Soll-Wert | Erfindung |
|---|---|---|
| Brennbarkeit (Nachbrennzeit nach Beflammung) | VO max. 50 s | 42 s |
| HPCT [s, kein Mißling] | > 15 | > 15 |
| Oberflächenwiderstand [Ohm] | > 1E10 | 7,4E10 |
| Durchgangswiderstand [Ohm cm] | > 5E11 | 4,8E12 |
| tan. delta | < 0,035 | 0,018 |
| Dielektrizitätskonstante | < 5,5 | 4,9 |
| T_{g} [°C] | > 160 | 178 |

## Patentansprüche

1. Epoxidharzsysteme enthaltend
a. mindestens eine stickstoffhaltige Epoxidverbindung mit mindestens zwei Epoxidgruppen,
b. mindestens eine Phosphorverbindung der folgenden Struktur : 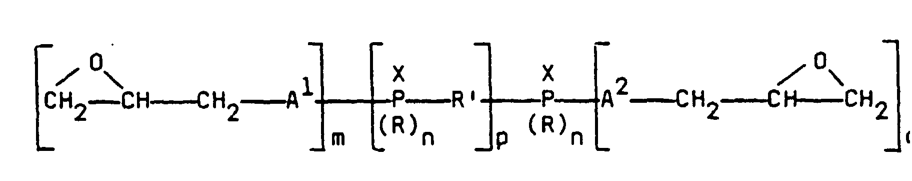 worin **m** = 0 oder 1; **n** = 0, 1 oder 2 und **o** = 1, 2 oder 3 mit der Maßgabe, daß m + n + o = 3; **p** = 0, 1 oder 2; **X** ein freies Elektronenpaar oder ein über eine Doppelbindung gebundenes O- oder S-Atom; **R** einen direkten oder über O oder S gebundenen Alkylrest mit 1 bis 4 C-Atomen, Alkenylrest mit 2 bis 3 C-Atomen, Arylrest, Aralkylrest, oder 3-Trialkylsilyl-propylrest; **R'** eine Brücke aus O, S, Phenylen Dioxyphenylen, Dioxynaphthylen, (CH₂)ᵣ, O-(CH₂)ᵣ, O-(CH₂)ᵣ-O oder O-(CH₂)ᵣ-(Si(CH₃)₂-O)ₛ-Si(CH₃)₂(CH₂)ᵣ-O mit **r** = 1 bis 3 und **s** = 1 bis 8 oder (O-CH₂-CH₂)ₜ-O, (O-CH(CH₃)-CH₂)ₜ oder (O-(CH₂)₄)ₜ-O mit **t** = 2 bis 100 bedeuten und A¹ und A², die gleich oder verschieden sein können und eine Einfachbindung oder ein Brücke entsprechend der Gruppierung R' bedeuten
c. mindestens eine Metallkomplexverbindung der Struktur
MLₓB_{y} oder M [SR]ₓ B_{z},
wobei
- M ein komplexierendes Metallion
- L ein Ligand
- SR ein Säurerestion
- B eine Lewis-Base
- x eine natürliche Zahl im Bereich von 1 bis 8
- y eine natürliche Zahl im Bereich von 1 bis 5
- z eine natürliche Zahl im Bereich von 7 bis 8
sind, als Härter, sowie
d. weitere Füll- und Zusatzstoffe, wobei sie die stickstoffhaltigen Epoxidverbindungen und die epoxidgruppenhaltigen Phosphorverbindungen im Gewichtsverhälnis von 50 : 50 bis 95 : 5 enthalten.

2. Epoxidharzsysteme nach Anspruch 1, **dadurch gekennzeichnet**, daß die stickstoffhaltige Epoxidverbindungen Tetraglycidyl-methylendianilin und/oder Tetraglycidyl-diaminodiphenylsulfon sind.

3. Epoxidharzsysteme nach den Ansprüchen 1 bis 2, **dadurch gekennzeichnet**, daß sie 0,1 bis 20 Gew.-Teile Metallkomplexverbindung auf 100 Gew.-Teile stickstoffhaltiger Epoxidverbindungen und epoxidgruppenhaltiger Phosphorverbindungen enthalten.

4. Verwendung der Epoxidharzsysteme gemäß der Ansprüche 1 bis 3 zur Herstellung von Leiterplattenbasismaterial.

5. Verwendung der Epoxidharzsysteme gemäß der Ansprüche 1 bis 3 zur Umhüllung oder Einbettung von elektrischen, elektronischen Bauelementen oder als Gießharz.

6. Verwendung der Epoxidharzsysteme gemäß der Ansprüche 1 bis 3 zur Herstellung von Prepregs.

## Claims

1. Epoxy resin compositions containing
a. at least one nitrogen-containing epoxy compound having at least two epoxy groups,
b. at least one phosphorus compound of the following structure 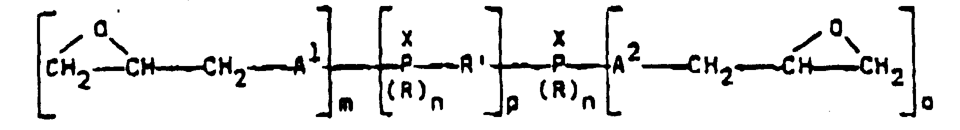 in which m = 0 or 1; n = 0, 1 or 2 and o = 1, 2 or 3 with the proviso that m + n + o = 3;
p = 0, 1 or 2; X denotes a free electron pair or an O or S atom linked via a double bond; R is linked directly or via O or S and is an alkyl radical having 1 to 4 C atoms, an alkenyl radical having 2 to 3 C atoms, an aryl radical, an aralkyl radical or a 3-trialkylsilylpropyl radical; R' denotes a bridge of O, S, phenylene, dioxyphenylene, dioxynaphthylene, (CH₂)ᵣ, O-(CH₂)ᵣ, O-(CH₂)ᵣ-O or O-(CH₂)ᵣ-(Si(CH₃)₂-O)ₛ-Si(CH₃)₂(CH₂)ᵣ-O wherein r = 1 to 3 and s = 1 to 8 or (O-CH₂-CH₂)ₜ-O, (O-CH(CH₃)-CH₂)ₜ or (O-(CH₂)₄)ₜ-O wherein t = 2 to 100 and A¹ and A² which may be the same or different and denote a single bond or a bridge corresponding to the grouping R'
c. at least one metal complex of the structure
MLₓB_{y} or M [SR] ₓ B_{z},
where
- M is a complexing metal ion
- L is a ligand
- SR is an acid radical ion
- B is a Lewis base
- x is a natural number within the range 1 to 8
- y is a natural number within the range 1 to 5
- z is a natural number within the range 7 to 8.
as a curing agent and
d. further fillers and additives,
with them containing the nitrogen-containing epoxy compounds and the epoxy-group-containing phosphorus compounds in a ratio by weight of from 50 : 50 to 95 : 5.

2. Epoxy resin compositions according to Claim 1, characterised in that the nitrogen-containing epoxy compounds are tetraglycidyl methylenedianiline and/or tetraglycidyl diaminodiphenylsulphone.

3. Epoxy resin compositions according to Claims 1 to 2, characterised in that they contain from 0.1 to 20 parts by weight of metal complex per 100 parts by weight of nitrogen-containing epoxy compounds and epoxy-group-containing phosphorus compounds.

4. Use of the epoxy resin compositions in accordance with Claims 1 to 3 for the preparation of basic material for printed circuit boards.

5. Use of the epoxy resin compositions in accordance with Claims 1 to 3 for encasing or embedding electrical or electronic components or as a casting resin.

6. Use of the epoxy resin compositions in accordance with Claims 1 to 3 for the preparation of prepregs.

## Revendications

1. Systèmes de résines époxydes contenant
a. au moins un composé époxyde azoté avec au moins deux groupes époxy,
b. au moins un composé de phosphore de la structure suivante 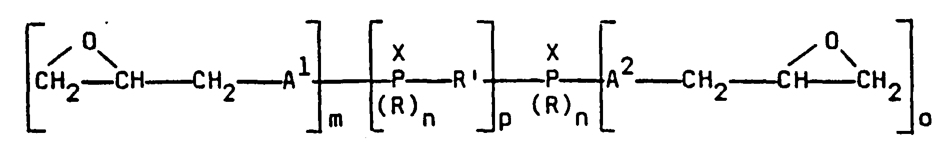 dans laquelle m = 0 ou 1; n = 0, 1 ou 2 et o = 1,2,ou 3 à condition que m + n + o = 3; p = 0,1 ou 2 ; x est une paire d'électrons libres ou un atome de O ou de S lié par l'intermédiaire d' une double liaison; R représente un reste alkyle avec 1 à 4 atomes de C direct lié par l'intermédiaire de O ou de S ; un reste alkylène avec 2 à 3 atomes de C , un reste aryle, un reste aralkyle, un reste dialkylamino ou dialkylarylamino ou un reste 3-trialkylsilylpropyle; R' représente un pont à partir de O, S, phénylène, dioxyphénylène, dioxynaphthylène, (CH₂)ᵣ, O-(CH₂)ᵣ, O-(CH₂)ᵣ-O ou O-(CH₂)ᵣ-(Si(CH₃)₂-O)ₛ-Si(CH₃)₂(CH₂)ᵣ-O avec r = 1 à 3 et s = 1 à 8 ou (O-CH₂-CH₂)ₜ-O, (O-CH(CH₃)-CH₂)ₜ ou (O-(CH₂)₄)ₜ-O avec t = 2 à 100 et dans laquelle A¹ et A², qui peuvent être identiques ou différents représentent une liaison simple ou un pont correspondant au groupement R',
c. au moins un composé de complexe métallique de la structure suivante
MLₓB_{y} ou M(SR)ₓB_{z} ,
où
- M est un ion métallique complexant
- L est un ligand
- SR est un ion de reste acide
- B est une base de Lewis
- x est une nombre entier dans la gamme de 1 à 8
- y est une nombre entier dans la gamme de 1 à 5
- z est une nombre entier dans la gamme de 7 à 8,
en tant que durcisseur ainsi que des matières de charge et additifs additionnels,
à l'occasion de quoi les systèmes contiennent les composés époxydes azotés et les composés de phosphore contenant des groupes époxy dans le rapport pondéral de 50:50 à 95:5.

2. Systèmes de résines époxydes selon la revendication 1, caracterisés en ce que les composés époxydes azotés sont la tétraglycidyl-méthylènedianiline et/ou la tétraglycidyl-diaminodiphénylsulfone.

3. Systèmes de résines époxydes selon les revendications 1 à 2, caractérisés en ce qu'ils contiennent 0,1 à 20 parties en poids de composé de complexe métallique pour 100 parties en poids de composés époxydes azotés et de composés de phosphore contenant des groupes époxy.

4. Utilisation des systèmes de résines époxydes selon les revendications 1 à 3 pour la fabrication de supports de plaquettes imprimées.

5. Utilisation des systèmes de résines époxydes selon les revendications 1 à 3 pour l'enrobage ou l'encapsulation de composants électriques, électroniques ou comme résine de coulée.

6. Utilisation des systèmes de résines 'poxydes selon les revendications 1 à 3 pour la fabrication de préimprégnés.
